# EUROPEAN PATENT APPLICATION

(11) **EP 4 761 513 A1**
(43) Date of publication of application: **17.06.2026**
(21) Application number: 25217878.5
(22) Date of filing: 24.11.2025
(51) Int. Cl.: H10D 84/01, H10D 84/83, H10D 84/85, H10D 30/01, H10D 30/00, H10D 84/03

(54) **MERGED NANORIBBON-BASED TRANSISTOR ALONG NANOCOMB TRANSISTOR RIBBON PATH**

(30) Priority: 13.12.2024 US 202418980192
(71) Applicant: Intel Corporation, Santa Clara, CA 95054 (US)
(72) Inventor: CHU, Tao, Portland, 97229 (US); GHANI, Tahir, Portland, 97229 (US); LIN, Chia-Ching, Portland, 97229 (US); LUO, Yanbin, Portland, 97229 (US); CHAO, Yu-Lin, Portland, 97229 (US); MLECZKO, Michal, Portland, 97229 (US); ZHANG, Yang, Rio Rancho, 87124 (US); LIN, Chung-Hsun, Portland, 97229 (US); YEUNG, Chun Wing, Portland, 97229 (US); XU, Guowei, Portland, 97229 (US); CHAO, Robin, Portland, 97209 (US); ZHANG, Feng, Portland, 97229 (US); HUNG, Ting-Hsiang, Santa Clara, 95051 (US); ZHANG, Kan, Hillsboro, 97123 (US); ZHONG, Yue, Portland, 97229 (US); HSU, Cheng-Hsiang, San Bruno, 94066 (US); LIU, Zhan, Dublin, 94568 (US); JO, Jaesung, Portland, 97205 (US)
(74) Representative: 2SPL Patentanwälte PartG mbB

(57) **Abstract**

Examples of integrated circuit (IC) structures with a merged nanoribbon-based transistor along a nanocomb transistor ribbon path are described herein. In one example, an extra wide "merged" nanoribbon-based transistor can be fabricated along the same ribbon path as a nanocomb transistor to take advantage of the area occupied by the spine of the nanocomb transistor in addition to the extra height made available by a double height cell. In one such example, a merged nanoribbon-based transistor can enable higher current while also improving the ratio of active area to dead space in the IC design.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIGS. 2A-2B are top-down plan views of examples of IC structures including a merged nanoribbon-based transistor along a nanocomb transistor ribbon path, in accordance with embodiments of the disclosure.
FIGS. 3A-3E illustrate different cross-sectional views of an example of an IC structure including a merged nanoribbon-based transistor along a nanocomb transistor ribbon path, in accordance with embodiments of the disclosure.
FIG. 4 is a flow diagram of an example method for fabricating an IC structure including a merged nanoribbon-based transistor along a nanocomb transistor ribbon path, in accordance with some embodiments.
FIGS. 5A-5C, 6A-6C, 7A-7C, 8A-8C, 9A-9C, and 10A-10C provide cross-sectional side views at various stages in the fabrication of an example IC structure according to the method of FIG. 4, in accordance with some embodiments.
FIG. 11 is a top view of a wafer and dies that may include any of the IC structures disclosed herein, in accordance with any of the embodiments disclosed herein.
FIG. 12 is a side, cross-sectional view of an IC device that may include any of the IC structures disclosed herein, in accordance with any of the embodiments disclosed herein.
FIG. 13 is a side, cross-sectional view of an IC package that may include any of the IC structures disclosed herein, in accordance with various embodiments.
FIG. 14 is a side, cross-sectional view of an IC device assembly that may include any of the IC structures disclosed herein, in accordance with any of the embodiments disclosed herein.
FIG. 15 is a block diagram of an example electrical device that may include any of the IC structures disclosed herein, in accordance with any of the embodiments disclosed herein.

### Detailed Description

Disclosed herein integrated circuit (IC) structures including a merged nanoribbon-based transistor along a nanocomb transistor ribbon path. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Integrated circuits may be designed using a library of cells. For example, a cell in such a library may define a pre-designed component or logic gate, such as an inverter, a flip-flop, or other component. Cells in a library may be designed to fit within defined physical and electrical standards so that the cells may be laid out in the desired locations to build the desired circuit. For example, cells may be "standard height" or "single height" cells with a pre-defined cell size (e.g., height and width), where the height may refer to a dimension of the cell along the y-axis in a top-down view, and the width may refer to a dimension of the cell along an x-axis in a top-down view. Other cells may be "double height," where a double height cell has a larger height than the standard cell (e.g., twice the height).

As the cell dimensions are scaled down, the dimensions of the transistors in those cells are also shrinking. For example, as cell height shrinks, the nanoribbon width of nanoribbon-based transistors in a cell also shrink. In some cases, smaller nanoribbon widths can negatively impact device performance, such as in high-current driver circuits. Another challenge encountered when scaling down the standard cell height is the worsening ratio of active regions to "dead space" or gaps without active regions (e.g., spacing or gaps that may be required by design rules). Using double height cells may address performance issues for high-current circuits, but scaled down double height cells may still suffer from a less than optimal ratio of active regions to dead space.

In accordance with examples described herein, an IC structure with a merged nanoribbon-based transistor along a nanocomb transistor ribbon path may enable higher current/higher performance circuits with less dead space in the design. In one example, an extra wide "merged" nanoribbon-based transistor can be fabricated along the same ribbon path as a nanocomb transistor to take advantage of the area occupied by the spine of the nanocomb transistor in addition to the extra height made available by a double height cell. In one such example, a merged nanoribbon-based transistor can enable higher current (e.g., along critical paths) while also improving the ratio of active area to dead space in the IC design.

For purposes of illustrating IC structures including a merged nanoribbon-based transistor along a nanocomb transistor ribbon path, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, trigate transistors, FinFETs, nanowire, and nanoribbon transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

A gate enclosure of a transistor refers to a portion of the gate stack which sets the amount of a "top-down" space that a gate stack consumes beyond the channel confinement surface. Conventional non-planar transistor architectures all utilize gate enclosures that not only consume space but also add parasitic capacitance, impacting area scaling, speed improvements, and energy savings. A nanocomb transistor architecture (also sometimes referred to as a forksheet architecture) has been proposed in the literature as a scaling booster to reduce the cell dimensions and parasitic capacitance, where the name "nanocomb/forksheet" arises because of its complex bilateral finned structure. In an example nanocomb transistor arrangement, the nanoribbons are coupled with a dielectric "spine" or wall, and there is no gate enclosure on one of the two sides of the vertical stack of lateral nanoribbons or nanosheets (referred to in the following as "nanoribbons"), while the gate enclosure on the other side still remains. In other examples, a nanocomb transistor arrangement may include a portion of the gate electrode material and/or gate insulator between the dielectric spine and the nanoribbons.

As used herein, the term "nanoribbon" refers to an elongated semiconductor structure having a long axis parallel to a support structure (e.g., a substrate, a chip, or a wafer) over which a transistor arrangement is provided. In some settings, the term "nanoribbon" has been used to describe an elongated semiconductor structure that has a rectangular transverse cross-section (i.e., a cross-section in a plane perpendicular to the longitudinal axis of the structure), while the term "nanowire" has been used to describe a similar structure but with a circular or square-like transverse cross-section. In the present disclosure, the term "nanoribbon" is used to describe both such nanoribbons (including nanosheets) and nanowires, as well as elongated semiconductor structures with a longitudinal axis parallel to the support structures and with having transverse cross-sections of any geometry (e.g., oval, or a polygon with rounded corners). As used herein, the term "face of a nanoribbon" refers to any of the confinement surfaces (i.e., interfaces of the semiconductor material of the nanoribbon with the gate stack) of the nanoribbon which are substantially parallel to the support structure when a nanoribbon extends in a direction parallel to the support structure, while the term "sidewall of a nanoribbon" refers to any of the confinement surfaces of the nanoribbon connecting the bottom face and the top face (the bottom face being the face of the nanoribbon that is closer to the support structure than the top face).

While the descriptions are provided herein with reference to nanoribbons, the principles of IC structures including a merged nanoribbon-based transistor along a nanocomb transistor ribbon path, described herein, are equally applicable to arrangements where a channel material is shaped as a structure where the length of the structure (e.g., a dimension measured along the y-axis of the example coordinate system shown in the present drawings) is similar to the thickness of the structure (e.g., a dimension measured along the z-axis of the example coordinate system shown in the present drawings).

IC structures as described herein, in particular IC structures including a merged nanoribbon-based transistor along a nanocomb transistor ribbon path as described herein, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures including a merged nanoribbon-based transistor along a nanocomb transistor ribbon path as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices (e.g., physically coupled, conductively coupled, e.g., directly electrically connected). A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

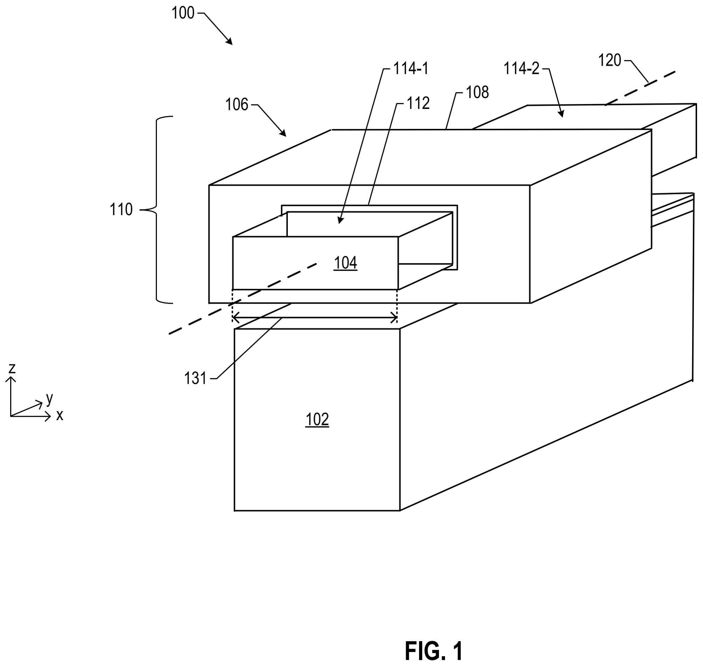

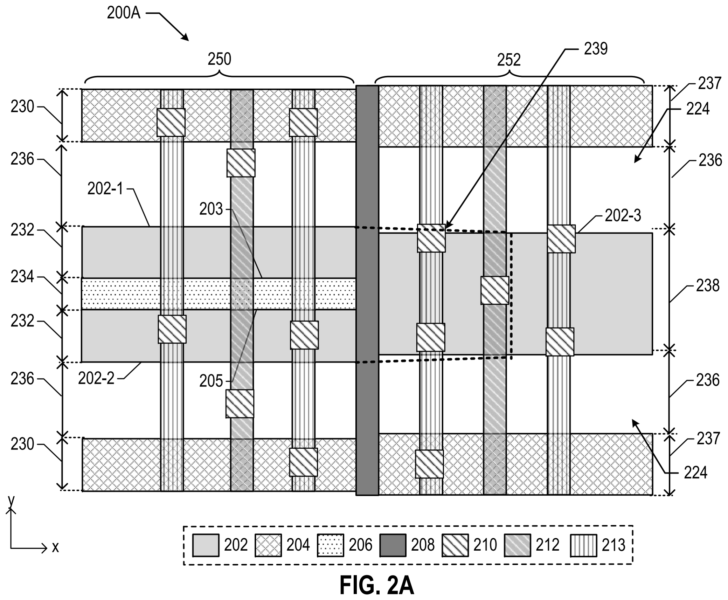

FIG. 1 provides a perspective view of an example IC structure 100 with a nanoribbon transistor 110, according to some embodiments of the present disclosure. For example, in various embodiments, the transistor 110 formed on the basis of a nanoribbon 104, shown in FIG. 1, may be formed on the basis of any of the nanoribbon-based transistor arrangements shown in any of FIGS. 2A-2B, 3A-3E, and 10A-10C. In some of those examples, the nanoribbon-based transistor arrangement is a nanocomb transistor that is formed in the stacks of lateral nanoribbons separated by a dielectric wall. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 (referred to herein as simply "S/D regions 114"), on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

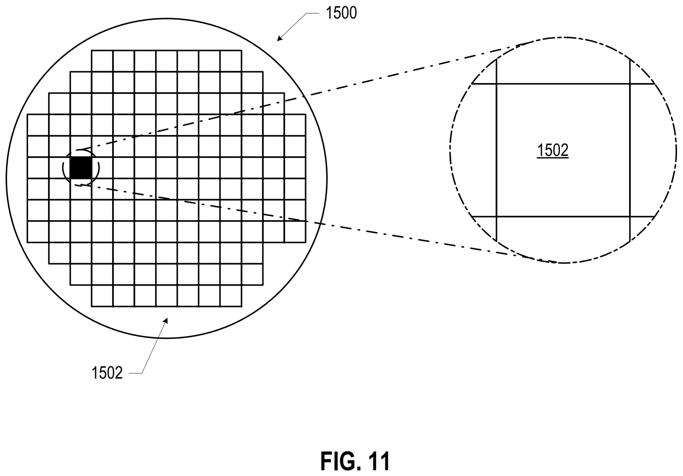

Implementations of the present disclosure may be formed or carried out on any suitable support 102, such as a substrate, a die, a wafer, or a chip. The support 102 may, e.g., be the wafer 1500 of FIG. 11, discussed below, and may be, or be included in, a die, e.g., the singulated die 1502 of FIG. 11, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC including a merged nanoribbon-based transistor along a nanocomb transistor ribbon path as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIGS. 2A-2B, 3A-3E, and 10A-10C show IC structures that may be or include examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width 131 of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some examples, nanoribbons of the same semiconductor material may be used to form NMOS and PMOS transistors. In such examples, the NMOS and PMOS transistors may be differentiated by depositing N-type or P-type work function metals around channel portions of those transistors.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided below.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. The channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIGS. 2A-2B are top-down plan views of examples of IC structures including a merged nanoribbon-based transistor along a nanocomb transistor ribbon path. A number of elements referred to in the description of FIGS. 2A-2B, 3A-3E, 5A-5C, 6A-6C, 7A-7C, 8A-8C, and 9A-9C with reference numerals are illustrated in these drawings with different patterns, with a legend showing the correspondence between the reference numerals and patterns being provided at the bottom of each drawing page containing FIGS. 2A-2B, 3A-3E, 5A-5C, 6A-6C, 7A-7C, 8A-8C, and 9A-9C. For example, the legend illustrates that FIGS. 2A use different patterns to show an N-type nanoribbon 204 and a P-type nanoribbon 202, and so on.

Referring to FIG. 2A, the IC structure 200A includes two stacks of nanoribbons 204 on either side of a stack of nanoribbons 202. The following description refers to the nanoribbons 204 as N-type nanoribbons that form the basis of NMOS transistors and the nanoribbons 202 as P-type nanoribbons that form the basis of PMOS transistors. In some examples, the N-type and P-type nanoribbons 204, 202 may have the same or substantially the same material composition. In one such example, the NMOS and PMOS transistors may be distinguished from one another based on the presence of one or more different gate electrode materials in their respective gate stacks.

The IC structure 200A illustrated in FIG. 2A includes a first portion or region 250 and a second portion or region 252. In the first region 250, a dielectric wall 206 is present in the stack of P-type nanoribbons 202. The dielectric wall 206 (which may also be referred to as a spine or backbone) may be a portion of a dielectric material that is substantially shaped like a wall that extends substantially orthogonally from the substrate. The dielectric wall 206 may extend through the stack of nanoribbons 202 in the region 250, such that portions of the nanoribbons 202 on either side of the dielectric wall 206 may be referred to as separate stacks of nanoribbons. For example, the nanoribbons 202 in the region 250 may be referred to as first nanoribbons 202-1 coupled with a first face or side 203 of the dielectric wall 206 and second nanoribbons 202-2 coplanar with the first nanoribbons 202-1 and coupled with a second face or side 205 of the dielectric wall 206. The nanoribbons 202-1, 202-2, and the dielectric wall 206 may form the basis of one or more nanocomb transistors in the region 250. The dielectric wall is absent from the portion of the P-type nanoribbon in the region 252 (e.g., a dielectric wall is absent from the nanoribbon 202-3 in the region 252). Accordingly, the nanoribbons 202-1, the nanoribbons 202-2, and the nanoribbons 202-3 maty be considered different portions of a same nanoribbon stack, where a dielectric wall 206 is present in the stack in the region 250.

In the example illustrated in FIG. 2A, the N-type nanoribbons 204 are separated from the P-type nanoribbon 202 by a space or gap 224, where the gap 224 may be a region without active devices. Metal gate lines 212 and S/D contact lines 213 may extend substantially perpendicular to the nanoribbons 202 and 204 and substantially parallel to one another, e.g., along the y-axis shown in FIG. 2A. FIG. 2A illustrates that the metal gate lines 212 and the S/D contact lines 213 may be provided in an alternating manner. Metal gate lines 212 may intersect gate contacts that are in conductive contact with the gate stacks 106 (not visible in the view of FIG. 2A) provided over channel portions of the nanoribbons 202 and 204, providing electrical connectivity to the gates of the nanoribbon transistors. Thus, portions of the gate contacts intersecting the gate stacks 106 are in conductive contact with the gate stacks 106 and serve as gate contacts for the transistors. Similarly, S/D contact lines 213 may intersect the S/D contacts provided over S/D regions 114 (not visible in the view of FIG. 2A) of the nanoribbons 202 and 204, providing electrical connectivity to the S/D regions 114 of the nanoribbon transistors. Thus, portions of the S/D contacts intersecting the S/D regions 114 are in conductive contact with the S/D regions 114 and serve as S/D contacts for the transistors. Conductive vias 210 may couple the metal gate lines 212 and the S/D contact lines 213 with conductive lines in a metal layer over the device region of the IC structure 200A. One or more isolation lines, such as the isolation region 208, may also be present in the IC structure. In one example, such isolation lines may be substantially parallel with the metal gate lines 212 and substantially orthogonal to the nanoribbons 202 and 204.

As mentioned briefly above, circuit design may be done using cells from a library. For example, referring to FIG. 2A, the boundaries of a cell (e.g., a standard or single height cell or double height cell) may be located at or between the boundary between an N-type diffusion region and a P-type diffusion region (e.g., between or at a boundary between an N-type nanoribbon and P-type nanoribbon). In the example illustrated in FIG. 2A, the nanoribbons 204 in the region 250 have a width 230, and the nanoribbons 202-1 and 202-2 have a width 232. The dielectric wall 206 has a width 234. The gaps 224 between the nanoribbons 204 and the adjacent nanoribbons 202 have a width of 236. In one example, the width 230 of the N-type nanoribbon 204 and the width 232 of the P-type nanoribbons 202-1 and 202-2 that are coupled with the dielectric wall 206 have about the same width. In the region 252 in FIG. 2A, the nanoribbon 202-3 has a width 238. In the example illustrated in FIG. 2A, the width 238 of the nanoribbon 202-3 is greater than or equal to the width 232 of the nanoribbon 202-1 plus the width 232 of the nanoribbon 202-2 (e.g., greater than or equal to about twice the width 232). In the example illustrated in FIG. 2A, the width 238 of the nanoribbon 202-3 is smaller than the combined width of the nanoribbons 202-1 and 202-2 and the dielectric wall 206 (e.g., smaller than the width 232 plus the width 232 plus the width 234). Thus, in the example illustrated in FIG. 2A, there is a transition region or "jog" in the IC structure, as shown with the dotted line 239. In the example in FIG. 2A, the spacing between nanoribbons is the same in both the regions 250 and 252. Therefore, the nanoribbons 204 have a greater width 237 in the region 252 than in the region 250 (e.g., the width 237 is greater than the width 230).

As can be seen in FIG. 2A, the nanoribbon 202-3 has a width 238 as if two nanoribbons were merged together. For example, the nanoribbon 202-3 may occupy the space (e.g., width) similar to the nanoribbons 202-1 and 202-2 and some or all of the dielectric wall 206. The wide nanoribbon 202-3 may be the basis in which higher performance transistors are formed. The ratio of active regions to dead space may also improved in the region 252 compared to a region without a merged nanoribbon along the same nanoribbon path as a nanocomb transistor.

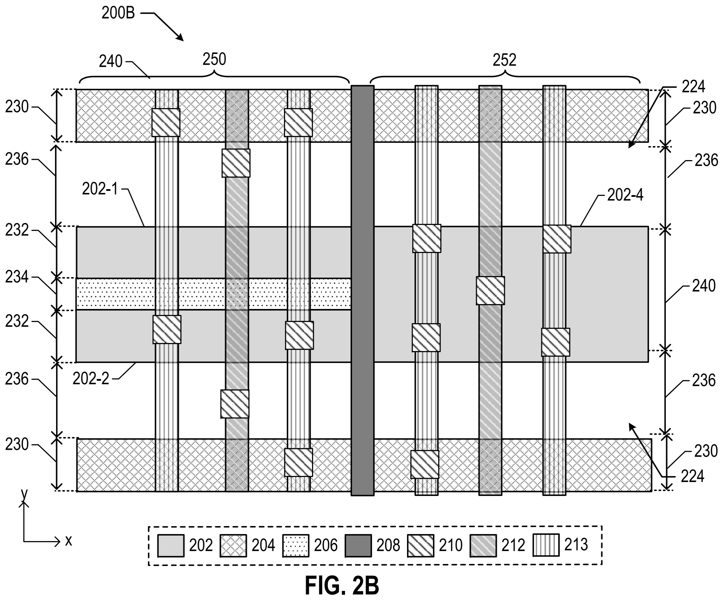

FIG. 2B illustrates another top-down plan view of an example of an IC structure 200B including a merged nanoribbon-based transistor along a nanocomb transistor ribbon path. The IC structure 200B is similar to the IC structure 200A of FIG. 2A with the exception of the nanoribbon widths in the region 252. As mentioned above, in FIG. 2A, the width 238 of the nanoribbon 202-3 is greater than the combined width of the nanoribbons 202-1 and 202-2, but less than the combined width of the nanoribbons 202-1 and 202-2 and the dielectric wall 206. In contrast, in FIG. 2B, the width 240 of the nanoribbon 202-4 is equal (e.g., substantially equal) to the width 232 of the nanoribbon 202-1 plus the width 234 of the dielectric wall 206 plus the width 232 of the nanoribbon 202-2. Like in FIG. 2A, adjacent nanoribbons 202 and 204 are separated by about the same distance (e.g., the gaps 224 between adjacent nanoribbons 202 and 204 have about the same width 236). Therefore, given the wider nanoribbon 202-4 in FIG. 2B, the nanoribbons 204 in the region 252 have about the same width 230 as the nanoribbons 204 in the region 250 (unlike in FIG. 2A where the width 237 of the nanoribbons 204 in the region 252 is greater than the width 230 of the nanoribbons 204 in the region 250).

Thus, FIGS. 2A and 2B illustrate examples of IC structures that include a merged nanoribbon-based transistor along a nanocomb transistor ribbon path. For example, nanocomb transistors may be formed in the nanoribbons 202-1 and 202-2 and other nanoribbon-based transistors may be formed in the nanoribbon 202-3, which is in the same nanoribbon path (e.g., along the same line or axis substantially parallel with the x-axis as shown in FIGS. 2A and 2B).

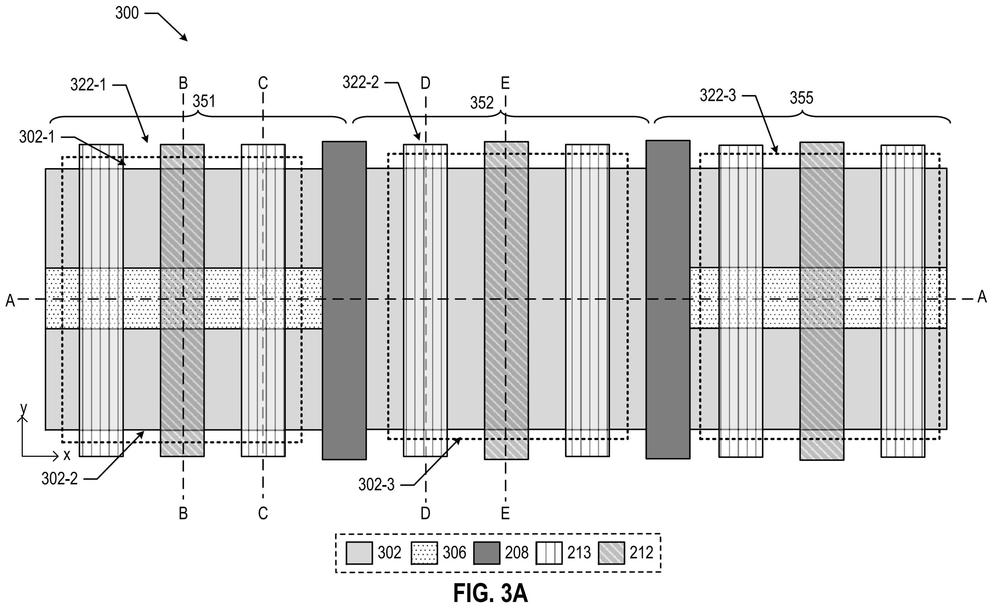

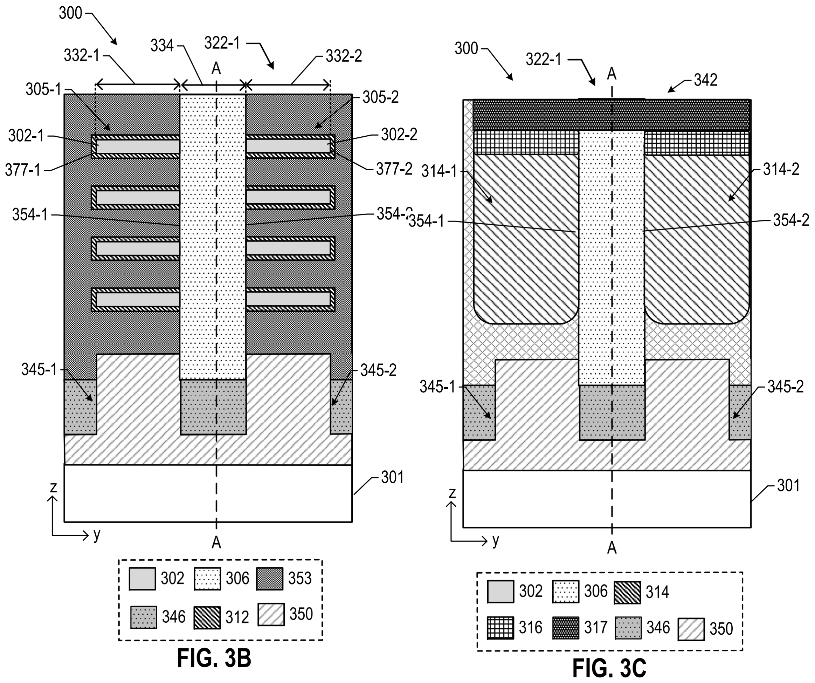

FIGS. 3A-3E illustrate different cross-sectional views of an example of an IC structure including a merged nanoribbon-based transistor along a nanocomb transistor ribbon path. FIG. 3A illustrates a top-down plan view of an IC structure 300. FIGS. 3B-3E illustrate different cross-sections in the y-z plane of the example coordinate system shown in FIG. 3A along planes BB, CC, DD, and EE, respectively, shown in FIG. 3A.

Turning to FIG. 3A, the top-down view of the IC structure 300 is similar to the view in FIGS. 2A-2B. The IC structure 300 includes a nanoribbon or stack of nanoribbons 302 extending along the x-axis shown in FIG. 3A. Similar to FIGS. 2A-2B, the IC structure includes metal gate lines 212, S/D contact lines 213, and isolation regions 208. The IC structure 300 includes a dielectric wall 306 in regions 351 and 355. In one perspective, in the regions 351 and 355 that include a dielectric wall 306, the nanoribbon portions on either side of the dielectric wall may be considered separate nanoribbons. For example, the nanoribbon 302 in the region 351 may include a first nanoribbon 302-1 and a second nanoribbon 302-2 separated by the dielectric wall 306. In one such example, the wide nanoribbon 302-3 in the region 352 extends from the ends of the nanoribbons 302-1 and 302-2 (e.g., the nanoribbon 302-1 and 302-3 may be considered substantially "end to end" extending along the same axis). Nanocomb transistors may be formed in the nanoribbon 302 in the regions 351 and 355. For example, a nanocomb transistor 322-1 may be formed in the region 351 and a nanocomb transistor 322-3 may be formed in the region 355. A region 352 between the regions 351 and 355 lacks the dielectric wall 206. Therefore, in the region 352, nanoribbon-based transistors may be formed in the nanoribbon 302 in the region 352, where a dielectric wall 306 is absent in such transistors. For example, a nanoribbon-based transistor 322-2 may be formed in the region 352. Thus, in the example illustrated in FIG. 2A, a transistor having an extra wide nanoribbon width (e.g., the transistor 322-2) may be between two nanocomb transistors 322-1 and 322-2 along the same nanoribbon path (e.g., on the same line or axis along which the nanoribbons extend).

FIG. 3B illustrates a cross-sectional view of the IC structure 300 along the plane BB shown in FIG. 3B. The view in FIG. 3B illustrates a gate view of a nanocomb transistor 322-2 in which a conductive material 353 (e.g., gate electrode material) at least partially surrounds portions of the nanoribbons 302. The IC structure 300 includes transistors similar to the transistor 110 but built on the basis of nanoribbon stacks of a plurality of nanoribbons instead of just one nanoribbon 104 as shown in FIG. 1. Specifically, the cross-section illustrated in FIG. 3B depicts a stack of nanoribbons 302 of a semiconductor material over a substrate 301. The substrate may be an example of the substrate 102 of FIG. 1. The IC structure includes a dielectric-filled trench (e.g., a dielectric wall 306) in the stack of nanoribbons 302. The stack may thus be referred to as two adjacent stacks of nanoribbons 202 (e.g., the stack 305-1 and the stack 305-2) on either side of the dielectric wall 306. While four nanoribbons 302 are shown to be included in the nanoribbon stacks 305-1, 305-2, in other embodiments, fewer nanoribbons 302 or more nanoribbons 302 may be included (e.g., two nanoribbons, three nanoribbons, five nanoribbons, etc.). The dielectric wall 306 is over and substantially orthogonal to the substrate 301, where the dielectric wall has a first side 354-1 and a second side 354-2 opposite the first side 354-1. In the example illustrated in FIG. 3B, the dielectric wall 306 has a width 334 (where the width 334 is a dimension of the dielectric wall 306 in a plane substantially parallel with the substrate 301). Nanoribbons of the stack 305-1 (e.g., the nanoribbon 302-1) are coupled with the first side 354-1 of the dielectric wall 306 and nanoribbons of the stack 305-2 (e.g., the nanoribbon 302-2) are coplanar with the nanoribbons of the first stack 305-1 and coupled with the second side 354-2 of the dielectric wall 306. The nanoribbons of the stack 305-1 have a width 332-1 (where the width 332-1 is a dimension of the nanoribbon 302-1 in a plane substantially parallel with the substrate 301 and extending away from the first side 354-1), and the nanoribbons of the stack 305-2 have a width 332-2 (where the width 332-2 is a dimension of the nanoribbon 302-2 extending away from the second side 354-2).

The IC structure also includes subfins 345-1, 345-2, including a first subfin 345-1 below and substantially aligned with the first stack 305-1 of nanoribbons 302 and a second subfin 345-2 below and substantially aligned with the second stack 305-2 of nanoribbons 302. The subfins 345-1, 345-2 in FIG. 3B are shown as including subfin replacement structures of an insulator material 350; however, in other examples, the subfins 345-1, 345-2 may include subfin structures that include the semiconductor material of the nanoribbons 302 and/or include semiconductor materials of different material compositions. In the example illustrated in FIG. 3B, another insulator material 346 lines the "shallow trench insulator" (STI) region between the subfins 345-1, 345-2. In some examples, the insulator material 346 and/or the insulator material 312 may be an oxide (e.g., silicon oxide, silicon oxynitride, carbon-doped silicon oxide, carbon-doped silicon oxynitride, or another suitable insulator material including oxygen). A gate stack having a gate insulator material 312 and a gate electrode material 353 wraps around channel portions of the nanoribbons 302.

For example, FIG. 3C illustrates an example cross-sectional view of the IC structure 300 along the plane CC shown in FIG. 3A. FIG. 3C illustrates an S/D region of a doped semiconductor material. Specifically, the IC structure includes a first S/D region 314-2 in the first nanoribbon stack 305-1 and a second S/D region 314-2 in a second nanoribbon stack 305-2, where the S/D region 314-1 is coupled with the side 354-1 of the dielectric wall 306 and the S/D region 314-2 is coupled with the side 354-2 of the dielectric wall 306. The S/D regions 314-1, 314-2 represent regions of a doped semiconductor material, and may be examples of the S/D regions 114 discussed above. Together, the S/D regions 314-1 and 314-2 may be either a source region or a drain region of a nanocomb transistor.

The IC structure 300 includes an S/D contact structure 342 that include a conductive material 317 for making electrical contact with the S/D regions 314-1, 314-2. FIG. 3C illustrates an IC structure 300 with front-side contact structures, however, in other examples, one or more contact structures may be formed from a back side of the wafer or IC structure. At the bottom of the S/D contact 342, an interface material 316 may be provided as an interface between the S/D regions 314-1, 314-2 and the electrically conductive fill material 317 of S/D contact 342. The interface material 316 may include/be a metal such as titanium which, once deposited, may intermix with the material of the S/D regions 314, e.g., with silicon, forming a compound (e.g., titanium silicide) that may help reduce contact resistance between the S/D regions 314 and the S/D contact structure 342.

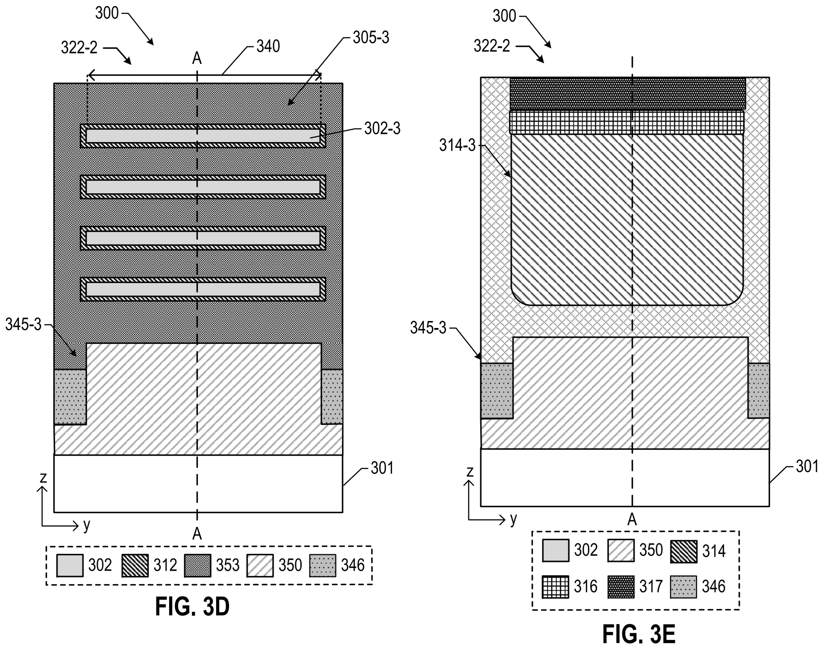

Thus, FIGS. 3B and 3C represent cross-sectional views in two different planes of an example of a nanocomb transistor 322-2. FIGS. 3D and 3E illustrate cross-sectional views of an example merged nanoribbon transistor in the same nanoribbon path as the nanocomb transistor of FIGS. 3B-3C. For example, referring to FIG. 3A, FIG. 3D illustrates a cross-sectional view along the plane DD in the region 352 and FIG. 3E illustrates a cross-sectional view along the plane EE in the region 352.

Turning to FIG. 3D, The view in FIG. 3D illustrates a gate view of a transistor 322-2 in which a conductive material 353 (e.g., gate electrode material) at least partially surrounds portions of the nanoribbons 302 of the wide stack 305-3. The IC structure 300 includes a subfin 345-3 below the stack 305-3 of nanoribbons. In the illustrated example, the stack 305-3 includes nanoribbons of a semiconductor material (e.g., the nanoribbon 302-3) that are coplanar with and parallel with the nanoribbons of the stacks 305-1 and 305-2 (e.g., as shown in FIG. 3B). For example, the nanoribbon 302-3 is substantially coplanar and parallel with the nanoribbons 302-1 and 302-3. The nanoribbons 302 of the stack 305-3 have a width 340 that is greater than or equal to the width 332-1 plus the width 332-2. Turning now to FIG. 3E, the view of the IC structure 300 in the plane EE illustrates one S/D region 314-3 (e.g., either a source region or a drain region) for the transistor 322-2. Thus, the transistor 322-2 illustrated in FIGS. 3D-3E is similar to the transistor 322-1 illustrated in FIGS. 3B-3C, except the transistor 322-1 includes the dielectric wall 306 and a dielectric wall is absent in the transistor 322-2. Additionally, the transistor 322-1 has a channel region in a stack 305-3 of nanoribbons that are wider than the nanoribbons 302-1 and 302-2.

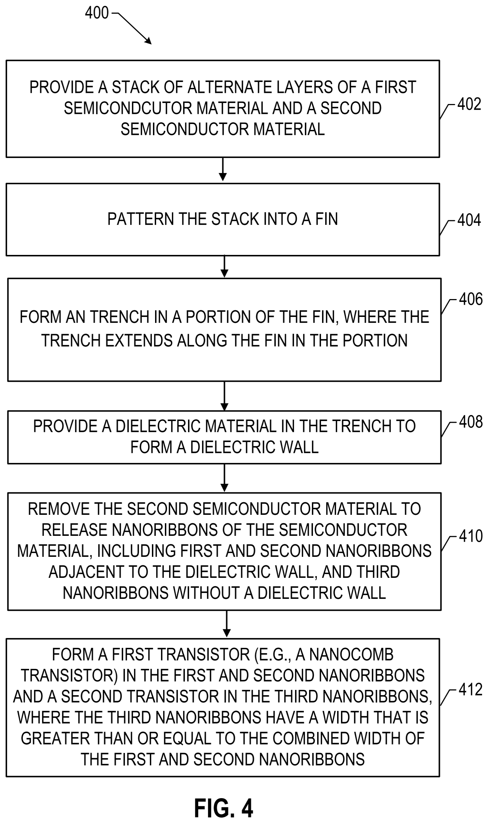

FIG. 4 is a flow diagram of an example method for fabricating an IC structure including a merged nanoribbon-based transistor along a nanocomb transistor ribbon path, in accordance with some embodiments.

Although the operations of the method of FIG. 4 are illustrated once each and in a particular order, the operations may be performed in any suitable order and repeated as desired. For example, one or more operations may be performed in parallel to fabricate multiple IC structures including a merged nanoribbon-based transistor along a nanocomb transistor ribbon path substantially simultaneously. In another example, the operations may be performed in a different order to reflect the structure of an IC structure including a merged nanoribbon-based transistor along a nanocomb transistor ribbon path.

In addition, the example fabricating method of FIG. 4 may include other operations not specifically shown in FIG. 4, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 4 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

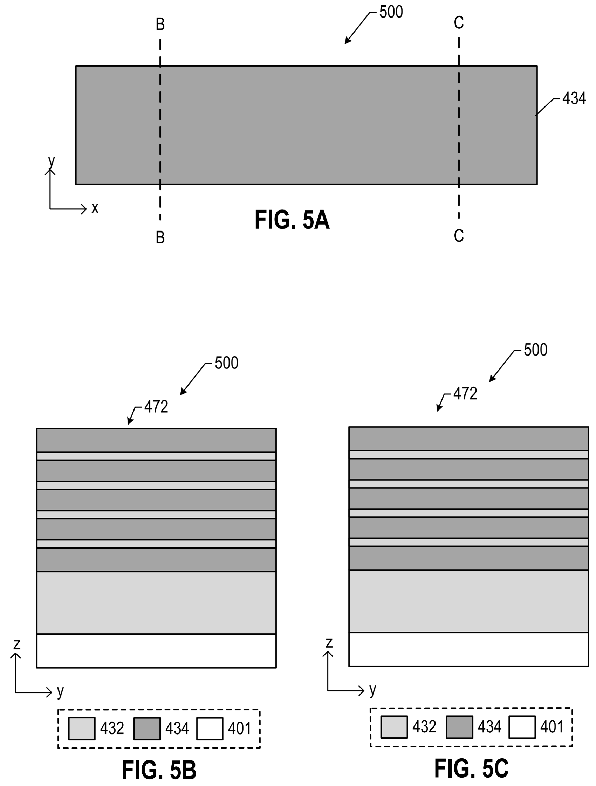

FIGS. 5A-5C, 6A-6C, 7A-7C, 8A-8C, 9A-9C, and 10A-10C provide cross-sectional side views at various stages in the fabrication of an example IC structure according to the method of FIG. 4, in accordance with some embodiments. The figures of FIGS. 5A-5C, 6A-6C, 7A-7C, 8A-8C, 9A-9C, and 10A-10C that are labeled with the letter A (e.g., FIG. 5A) illustrate top-down views in the x-y plane. The figures of FIGS. 5A-5C, 6A-6C, 7A-7C, 8A-8C, 9A-9C, and 10A-10C that are labeled with the letter B (e.g., FIG. 5B) illustrate cross-sectional side views in the y-z plane along a plane BB shown in the corresponding figure labeled with a letter A (e.g., in FIG. 5A). The figures of FIGS. 5A-5C, 6A-6C, 7A-7C, 8A-8C, 9A-9C, and 10A-10C that are labeled with the letter C (e.g., FIG. 5C) illustrate cross-sectional side views in the y-z plane along a plane CC shown in the corresponding figure labeled with a letter A (e.g., in FIG. 5A).

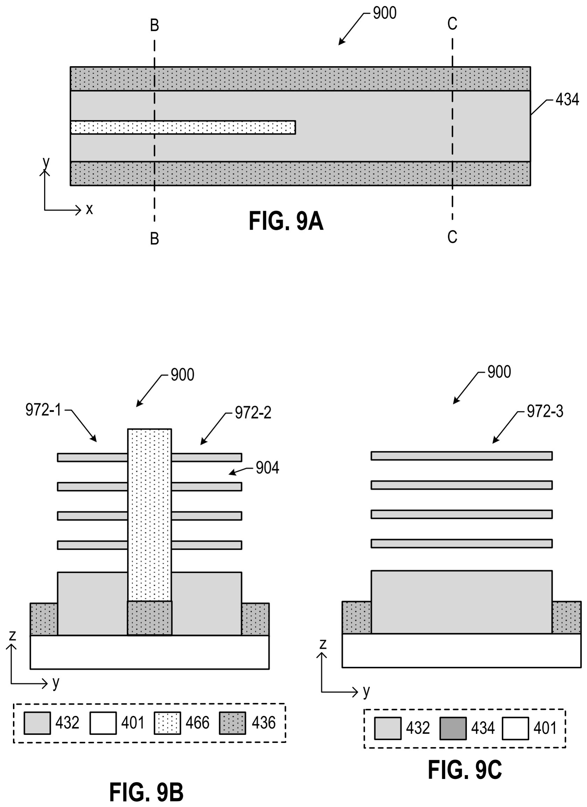

Turning to FIG. 4, the method 400 begins with a process 402 of providing a stack of alternate layers of a first semiconductor material and a second semiconductor material. The IC structure 500 of FIGS. 5A-5C is an example resulting IC structure of the process 402. The IC structure 500 includes a support 401 and alternating layers of a semiconductor material 432 and layers of another material 434. While FIGS. 5A-5C illustrate five layers of the semiconductor material and four layers of the material 434 in a stack 472, in other embodiments, any other number of layers may be used as long as they are alternating and include at least three layers of the semiconductor material 432 and at least two layers of the material 434. The upper layers of the semiconductor material 432 will later be formed into nanoribbons stacked above one another, as shown in FIGS. 9B-9C, discussed below. Thus, although a particular number of nanoribbons formed of the upper layers of the semiconductor material 432 is depicted in FIGS. 9B-9C (namely, four nanoribbons), embodiments of the present disclosure include IC structures having more or fewer stacked nanoribbons than depicted.

As shown in FIGS. 5A-5C, in some embodiments, the alternation of layers of the semiconductor material 432 and the material 434 may begin after a bottom layer of the semiconductor material 432 is provided over the support 401. In one such example, the bottom layer of the semiconductor material 432 may later form a subfin under the stack of nanoribbons. Although the thickness of the bottom layer of the semiconductor material 432 is depicted as being greater than the subsequent layers of the semiconductor material 432 that are formed into nanoribbons via further processing, in other examples, the bottom layer of the semiconductor material 432 may have a substantially same thickness as another layer of the semiconductor material 432.

The semiconductor material 432 may be any of the semiconductor/channel materials described above with reference to the nanoribbon 104 of FIG. 1. The material 434 may be any suitable material that is etch-selective with respect to the semiconductor material 432 so that, in a later process, the material 434 may be etched away to form nanoribbons of the semiconductor material 432. As known in the art, two materials are said to be "etch-selective" (or said to have "sufficient etch selectivity") with respect to one another when etchants used to etch one material do not substantially etch the other, enabling selective etching of one material but not the other. For example, in some embodiments, the semiconductor material 432 may be silicon while the material 434 may be a second semiconductor material such as silicon germanium. In another example, the semiconductor material 432 may be silicon germanium, while the material 434 may be silicon. In other examples, the material 434 may be made of a non-semiconductor material, e.g., of an insulator material, as long as this material is sufficiently etch-selective with respect to the semiconductor material 432.

Thus, the material 434 may be any suitable sacrificial material that is etch-selective with respect to the semiconductor material 432. Selecting the material 434 to be a semiconductor material may be particularly advantageous because it may improve quality of the semiconductor material 432 if the semiconductor material 432 is epitaxially grown on the material 434. In some embodiments, the process 402 may include epitaxially growing layers of the semiconductor material 432 and the material 434 (e.g., a second semiconductor material) in an alternating manner. In other embodiments, alternate layers of the semiconductor material 432 and the material 434 may be provided in the process 402 using other techniques, such as layer transfer or thin-film deposition. Although FIGS. 5A-5C illustrates the same semiconductor material 432 in various layers of the IC structure 500, in general, material compositions of a semiconductor material from which nanoribbons will later be formed in different layers of the IC structure 500 may be different. For example, the semiconductor material 432 of one layer of the IC structure 500 may be silicon while the semiconductor material 432 of another layer of the IC structure 500 may be a III-N semiconductor material such as GaN.

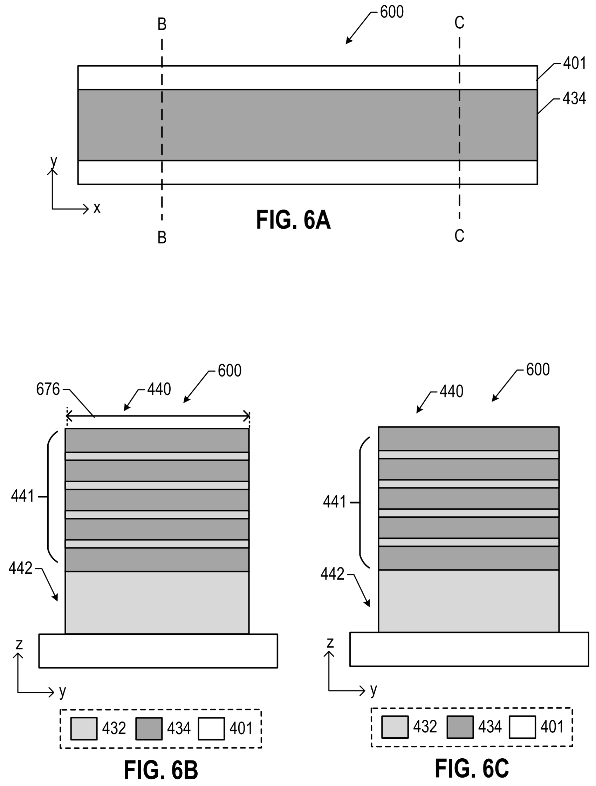

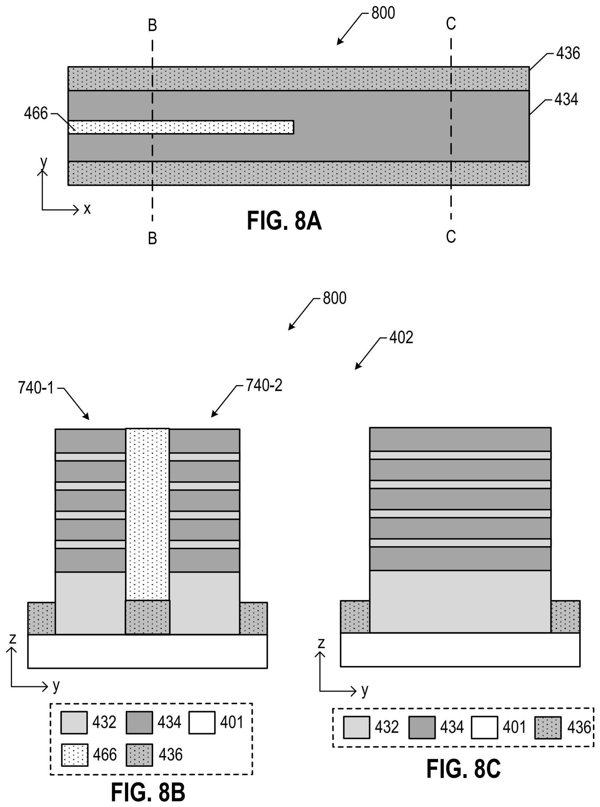

The method 400 continues with a process 404 of patterning the stack into a fin. FIGS. 6A-6C illustrate an example of an IC structure 600 resulting from the process of forming a fin from the stack of alternate layers of semiconductor material and another material. The IC structure 600 illustrates that the stack 472 of alternating layers of the semiconductor material 432 and the material 434, has been patterned into a fin 440. The fin 440 may include an active portion 441 and a subfin 442. The active portions 441 may be a portion of the fin 440 from which the respective nanoribbons will be formed, while the subfin 442 is a portion of the fin 440 that will have sidewalls at least partially enclosed with an insulator material 436, e.g., as shown in FIGS. 8A-8C, discussed below.

Thus, the fin 440 may be shaped as a structure that extends away from the support 401 and may include a subfin 442 at the bottom. In some embodiments, the subfin 442 may include the bottom layer of the semiconductor material 432, as well as an upper portion of the support 401, as is shown in FIGS. 6B-6C. However, in other embodiments, the subfin 442 may include only the semiconductor material 432 and not any portions of the support 401 (not shown in the present drawings). In some embodiments, semiconductor material 432 of the subfin 442 and/or the support 401 may be removed and/or replaced with one or more other materials in subsequent processes.

In some embodiments, the fin 440 may have a width 676 (i.e., a dimension of the fin 440 measured along the y-axis of the example coordinate system shown in FIGS. 6A-6C). The of the fin may be that of the width of the nanoribbons subsequently formed (e.g., the nanoribbon 104 of FIG. 1 described above). The fin 440 may further have a length (i.e., a dimension of the fin 440 measured along the x-axis of the example coordinate system shown in FIGS. 6A-6C) suitable to account for the length of the future nanoribbons (e.g., as described above with reference to the length of the nanoribbon 104 of FIG. 1).

In various embodiments, any suitable patterning techniques may be used to form the fin 440, such as, but not limited to, photolithographic or electron-beam (e-beam) patterning, possibly in conjunction with a suitable etching technique, e.g., a dry etch, such as e.g., RF reactive ion etch (RIE) or inductively coupled plasma (ICP) RIE. In some embodiments, the etch performed to form the fin 440 may include an anisotropic etch, using etchants in a form of e.g., chemically active ionized gas (i.e., plasma) using e.g., bromine (Br) and chloride (CI) based chemistries. In some embodiments, during the etch to form the fin 440 the IC structure may be heated to elevated temperatures, e.g., to temperatures between about room temperature and 200 degrees Celsius, including all values and ranges therein, to promote that byproducts of the etch are made sufficiently volatile to be removed from the surface.

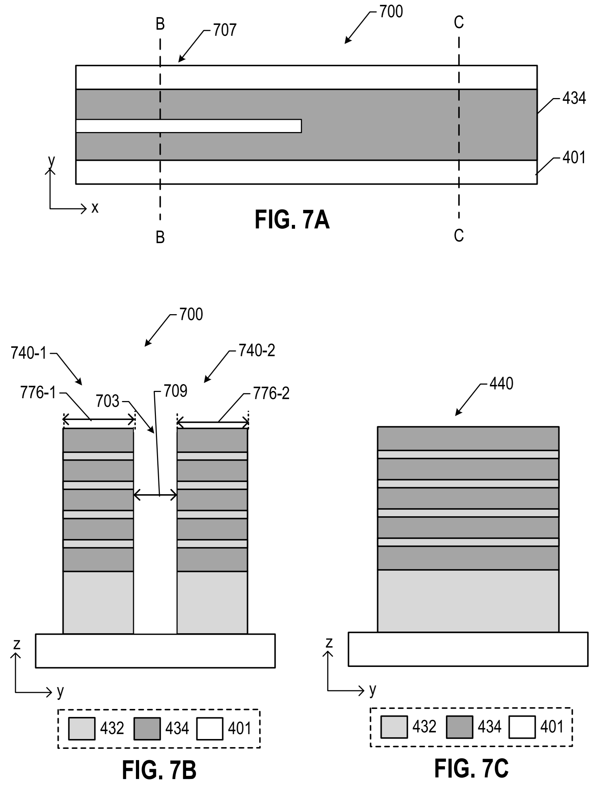

Referring again to FIG. 4, the method 400 continues with a process 406 of forming a trench in a portion of the fin, where the trench extends along the fin in the portion. The IC structure 700 of FIGS. 7A-7C is an example resulting IC structure of the process 406. The IC structure 700 illustrates that a trench opening 703 is formed substantially in the center of the fin 440 in the portion 707 and that the trench opening 703 extends along the length of the fin 440. In various embodiments, any suitable patterning techniques may be used in the process 406 to form the trench opening 703, e.g., any of those described above with reference to forming the fin 440. The trench opening 703 may have a width 709, and may divide the fin 440 into a first stack portion 740-1 having a width 776-1 and a second stack portion 740-2 having a width 776-2. In some embodiments, the width 709 may be between about 10 and 25 nanometers, including all values and ranges therein. In some embodiments, the trench opening 703 may extend all the way to the support 401, as is shown in the IC structure 700. In other embodiments, the trench opening 703 may be such that it does not reach all the way down to the support 401.

The method 400 continues with the process 408 of providing a dielectric material in the trench to form a dielectric wall. The IC structure 800 of FIGS. 8A-8C is an example resulting IC structure of the process 408. The IC structure 800 illustrates a dielectric material 466 filling the trench opening 703. The dielectric material 466 may be deposited into the trench opening 703 using any suitable technique such as ALD, CVD, spin-coating, or dip-coating. The dielectric material 466 may include any suitable dielectric materials, e.g., any of the materials described above with references to low-k or high-k dielectric materials. In the example illustrated in FIGS. 8A-8B, insulator material 436 may be deposited around the subfin regions prior to depositing the dielectric material 466. The insulator material 436 may include any insulator material typically used as an STI in fin-based or nanoribbon-based transistors, e.g., any suitable low-k dielectric material or other suitable insulator material.

Referring again to FIG. 4, the method continues with the process 410 of removing the second semiconductor material to release nanoribbons of the semiconductor material. The IC structure 900 of FIGS. 9A-9C is an example resulting IC structure of the process 410. Removal of the second semiconductor material 434 may include any suitable etching technique. As a result of removing the material 434, a first stack of nanoribbons 972-1 of the semiconductor material 432 is formed from the first stack portion 740-1, a second stack of nanoribbons 972-2 is formed from the second stack portion 740-2, and a third stack of nanoribbons 972-3 of the semiconductor material 432 is formed from the fin 440. In the example illustrated in FIGS. 9A-9C, there are four nanoribbons in each of the stacks, although the stacks could include fewer than or more than four nanoribbons. Thus, the nanoribbons 972-1, 972-2, and 972-3 are "released" in that the openings 904 are formed around channel portions of the nanoribbons 972-1, 972-2, and 972-3 of the semiconductor material 432.

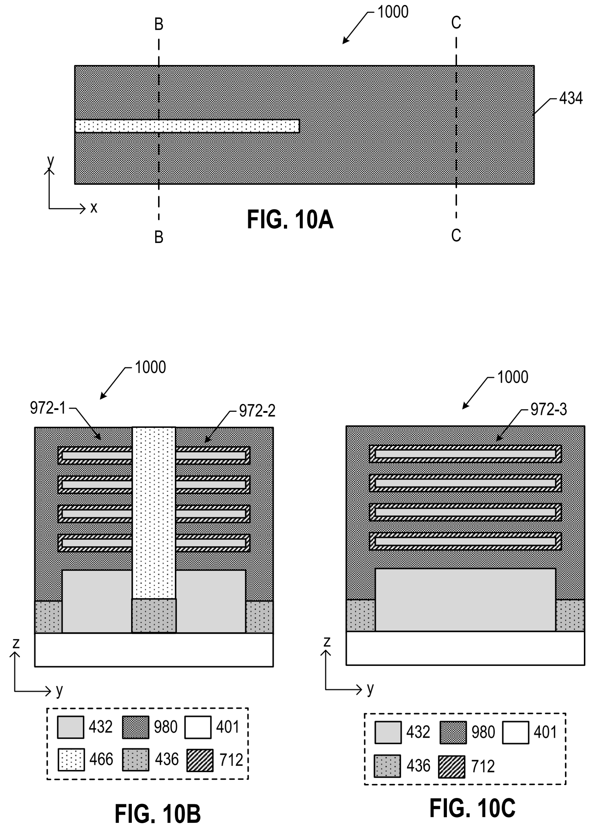

The method may continue with a process 412 of forming a first transistor (e.g., nanocomb transistor) in the first and second nanoribbons, and a second transistor in the third nanoribbons. Forming transistors may involve processes such as forming S/D regions (e.g., prior to releasing the nanoribbons), providing a gate insulator material around gate regions of the nanoribbons, and providing a gate electrode material at least partially around the nanoribbons. The IC structure 1000 of FIGS. 10A-10C is an example IC structure resulting from the process of forming a first and second transistor in the nanoribbons. As can be seen in FIGS. 10A-10C, the IC structure 1000 includes a gate insulator material 712 at least partially around the nanoribbons 972-1, 972-2, and 972-3. In the example illustrated in FIGS. 10A-10C, the gate insulator material is around three sides of the nanoribbons 972-1, around three sides of the nanoribbons 972-2, and around four sides of the nanoribbons 972-3. In other examples, the gate insulator material 712 may be present between the nanoribbons 972-1 and the dielectric wall 466 and/or between the nanoribbons 972-2 and the dielectric wall 466. The gate insulator material 712 may be an example of the gate insulator material 112. In some embodiments, the gate insulator material 712 may be absent in the IC structure 700. The IC structure also includes a conductive material 980 at least partially around the nanoribbons 972-1, 972-2, and 972-3. In the example illustrated in FIGS. 10A-10C, the conductive material 980 is around three sides of the nanoribbons 972-1, around three sides of the nanoribbons 972-2, and around four sides of the nanoribbons 972-3. In other examples, the conductive material 980 may be present between the nanoribbons 972-1 and the dielectric wall 466 and/or between the nanoribbons 972-2 and the dielectric wall 466. The conductive material 980 may be an example of the gate electrode material 108 discussed above.

Thus, the method 400 is an example method of fabricating an IC structure including a merged nanoribbon-based transistor along a nanocomb transistor ribbon path. Performing the method 400 may result in features in the final IC structures that are characteristic of the use of the method 400. For example, one such feature is illustrated in the IC structure 300 shown in FIGS. 3A-3E, in which the IC structure 300 includes a first nanoribbon 302-1 and a second nanoribbon 302-2 of a semiconductor material over a substrate 301, where the first nanoribbon 302-1 and the second nanoribbon 302-2 are coplanar and parallel with one another, a region of a dielectric material (e.g., the dielectric wall 306) between, coplanar with, and coupled with the first nanoribbon 302-1 and the second nanoribbon 302-2, where a combined width of the first nanoribbon 302-2, the region (e.g., the dielectric wall 306), and the second nanoribbon 302-2 is a dimension between a first plane at a first edge 377-1 of the first nanoribbon 302-1 and a second plane at a second edge 377-2 of the second nanoribbon 302-2 and in a third plane substantially parallel to the substrate 301 (e.g., where the first plane and the second plane are parallel with a first length of the first nanoribbon 302-1 and substantially orthogonal to the substrate 301, as represented by the dotted lines at the edges 377-1 and 377-2). The IC structure 300 further includes a third nanoribbon 302-3 of the semiconductor material, where the third nanoribbon is coplanar with and substantially parallel with the first nanoribbon 302-1, and the third nanoribbon 302-3 has a width between the first plane and the second plane, wherein the width 340 that is a dimension of the third nanoribbon 302-3 in the third plane (e.g., in the x-y plane shown in FIGS. 3A-3E).

Another such feature is shown in FIGS. 3A-3E, which show that the third nanoribbon 302-3 is along the same line or axis as the dielectric wall 306 in addition to the nanoribbons 302-1 and 302-2. For example. The third nanoribbon 302-3 is in a plane that is substantially orthogonal to the substrate 301, substantially parallel with the first nanoribbon 302-1, where the plane intersects the dielectric wall 306. Similarly, in the examples in FIGS. 3A-3E, an S/D region of a transistor in the nanoribbon 302-3 is along the same line or axis as the dielectric wall 306. For example, the IC structure 300 includes a first transistor 322-1 including a first channel region in a first portion of the first nanoribbon and a second portion of the second nanoribbon (e.g., portions of the nanoribbons 302-1, 302-2 shown in FIG. 3B), and a second transistor including a third channel region in a third portion of the third nanoribbon (e.g., a portion of the nanoribbon 302-3 shown in FIG. 3D) and a doped semiconductor region (e.g., the region 314-3) in the third nanoribbon 302-3, where the doped semiconductor region is in a plane with the region of the dielectric material (e.g., in a plane with the dielectric wall 306) that is substantially orthogonal to the substrate and substantially parallel to the first nanoribbon 302-1.

IC structures including a merged nanoribbon-based transistor along a nanocomb transistor ribbon path as described herein (e.g., as described with reference to FIGS. 1, 2A-2B, 3A-3E, 4, 5A-5C, 6A-6C, 7A-7C, 8A-8C, 9A-9C, and 10A-10C) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 200A, 200B, 300 and 1000, may be included in any suitable electronic component. FIGS. 11-15 illustrate various examples of apparatuses that may include the IC structures 200A, 200B, 300 and 1000 disclosed herein.

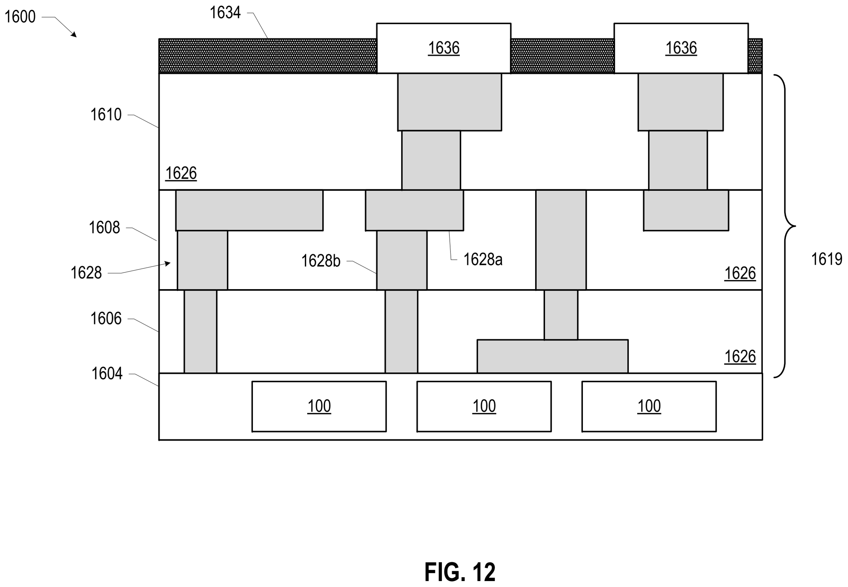

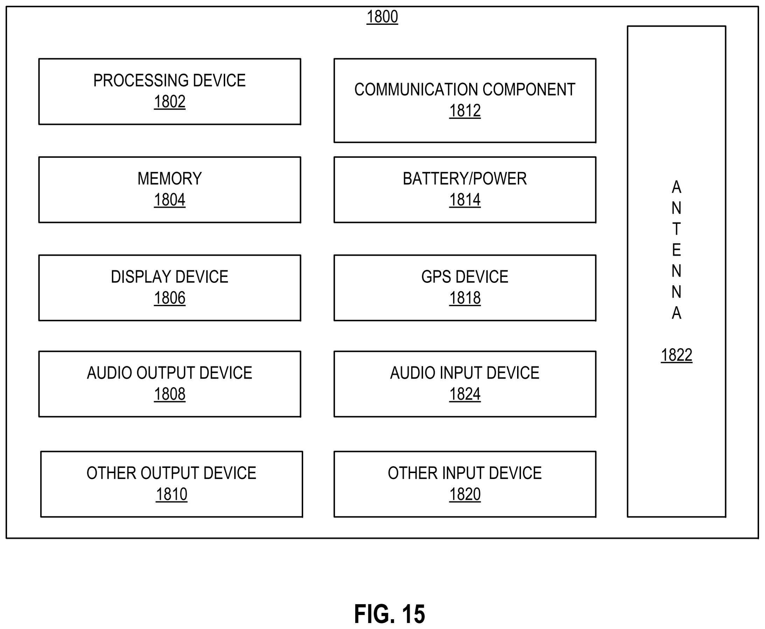

FIG. 11 is a top view of a wafer 1500 and dies 1502 that may include one or more IC structures 200A, 200B, 300 and 1000 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 200A, 200B, 300 and 1000 (e.g., as discussed below with reference to FIG. 12), one or more transistors (e.g., some of the transistors of the device region 1604 of FIG. 12, discussed below, e.g., nanoribbon-based transistors of the IC structures 200A, 200B, 300 and 1000) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 15) or other logic that is configured to store information in the memory devices or execute instructions stored in the memory array.

FIG. 12 is a side, cross-sectional view of an IC device 1600 that may include one or more IC structures in accordance with any of the embodiments disclosed herein (e.g., in accordance with IC structures 200A, 200B, 300 and 1000). One or more of the IC devices 1600 may be included in one or more dies 1502 (FIG. 11). The IC device 1600 may include a device region 1604 including one or more IC structures (e.g., one or more of IC structures 200A, 200B, 300 and 1000) disclosed herein, or any variations of the IC structures. The device region 1604 may further include electrical contacts to the gates of the transistors included in the device region 1604 and to the S/D materials of the transistors included in the device region 1604 (e.g., to the S/D regions 114 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 12 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 12). Although a particular number of interconnect layers 1606-1610 is depicted in FIG. 12, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 12. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 12. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114 of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 12, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

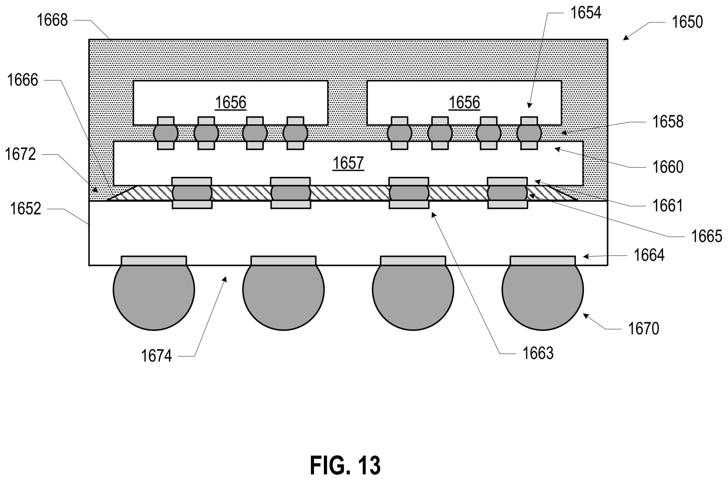

FIG. 13 is a side, cross-sectional view of an example IC package 1650 that may include one or more IC structures 200A, 200B, 300 and 1000 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 12.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 13 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 13 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

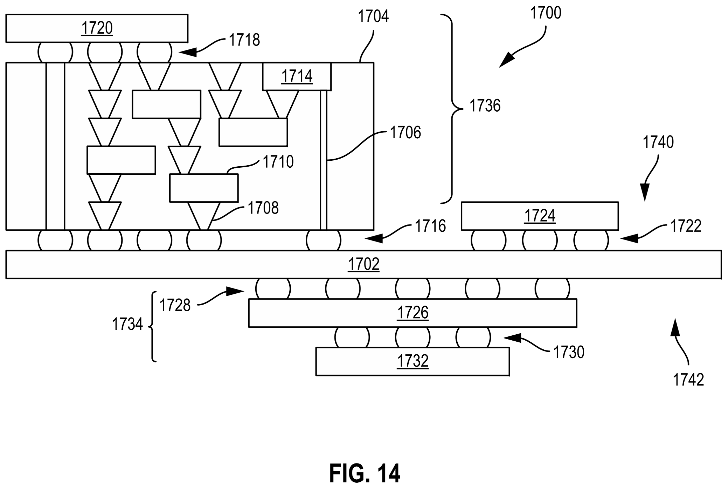

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 13 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 14.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 13 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 13, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 14 is a side, cross-sectional view of an IC device assembly 1700 that may include one or more IC packages or other electronic components (e.g., a die) including one or more IC structures 200A, 200B, 300 and 1000 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 13 (e.g., may include one or more IC structures 200A, 200B, 300 and 1000).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 14 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 14), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 14, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 11), an IC device (e.g., the IC device 1600 of FIG. 12), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 14, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 14 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 15 is a block diagram of an example electrical device 1800 that may include one or more IC structures 200A, 200B, 300 and 1000 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 15 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 15, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a first nanoribbon and a second nanoribbon (e.g., nanoribbons on either side of the spine) of a semiconductor material over a substrate, where: the first nanoribbon and the second nanoribbon are coplanar and substantially parallel with one another, the first nanoribbon has a first width, where the first width is a dimension of the first nanoribbon in a plane substantially parallel with the substrate, and the second nanoribbon has a second width, where the second width is a dimension of the second nanoribbon in the plane; a region of a dielectric material (e.g., spine) between, coplanar with, and coupled with the first nanoribbon and the second nanoribbon; and a third nanoribbon (e.g., the merged nanoribbon) of the semiconductor material, where: the third nanoribbon is coplanar with, substantially parallel with the first nanoribbon, and extending along a same line as the first nanoribbon, the third nanoribbon has a third width, where the third width is a dimension of the third nanoribbon in the plane, and the third width is greater than the first width.

Example 2 provides the IC structure of example 1, where: the third nanoribbon is in a second plane that is substantially orthogonal to the substrate, substantially parallel with the first nanoribbon, and intersecting the region of the dielectric material.

Example 3 provides the IC structure of any one of examples 1-2, further including a first transistor including a first channel region in a first portion of the first nanoribbon and a second portion of the second nanoribbon; and a second transistor including a third channel region in a third portion of the third nanoribbon and a doped semiconductor region in the third nanoribbon, where the doped semiconductor region is a source region or a drain region of the second transistor, where: the doped semiconductor region is in a second plane with the region of the dielectric material, where the second plane is substantially orthogonal to the substrate and substantially parallel with the first nanoribbon.

Example 4 provides the IC structure of example 3, where the first transistor includes a first nanocomb transistor, and where the IC structure further includes a second nanocomb transistor, where the second transistor is between the first nanocomb transistor and the second nanocomb transistor.

Example 5 provides the IC structure of any one of examples 1-4, where: the first nanoribbon has a first width, the second nanoribbon has a second width, the width of the third nanoribbon is a third width, and the third width is greater than or equal to the first width plus the second width.

Example 6 provides the IC structure of example 5, where: the region has a fourth width, and the third width is substantially equal to the first width plus the second width plus the fourth width.

Example 7 provides the IC structure of example 5, where: the region has a fourth width, and the third width is smaller than the first width plus the second width plus the fourth width.

Example 8 provides the IC structure of any one of examples 1-7, further including a fourth nanoribbon coplanar with, substantially parallel with, and adjacent to the third nanoribbon and the first nanoribbon, where: the fourth nanoribbon includes a first portion adjacent to the third nanoribbon, where the first portion has a fourth width, and a second portion adjacent to the first nanoribbon, where the second portion has a fifth width, and the fourth width is greater than the fifth width (e.g., an adjacent N-type nanoribbon may have a greater width adjacent to the merged nanoribbon than adjacent to the nanocomb transistor).

Example 9 provides the IC structure of any one of examples 1-8, where: the first nanoribbon, the second nanoribbon, and the third nanoribbon are different portions of a same nanoribbon.

Example 10 provides an IC structure, including a dielectric wall over and substantially orthogonal to a substrate, where the dielectric wall has a first side and a second side opposite the first side; a first nanoribbon of a semiconductor material coupled with the first side and a second nanoribbon of the semiconductor material coplanar with the first nanoribbon and coupled with the second side, where: the first nanoribbon has a first width, where the first width is a first dimension of the first nanoribbon in a plane substantially parallel with the substrate and extending away from the first side, the second nanoribbon has a second width, where the second width is a second dimension of the second nanoribbon in the plane and extending away from the second side; and a third nanoribbon of the semiconductor material coplanar with and substantially parallel with the first nanoribbon and the second nanoribbon, where: the third nanoribbon extends from a first end of the first nanoribbon and a second end of the second nanoribbon, the third nanoribbon has a third width in the plane, and the third width is greater than or equal to the first width plus the second width.

Example 11 provides the IC structure of example 10, where: the dielectric wall has a fourth width in the plane, and the third width is smaller than or equal to the first width plus the second width plus the fourth width.

Example 12 provides the IC structure of any one of examples 10-11, where: the third nanoribbon and the dielectric wall are in a line substantially parallel with the substrate.

Example 13 provides the IC structure of any one of examples 10-12, further including a first transistor and a second transistor in a line substantially parallel with the substrate, where: the first transistor includes a first channel region in a first portion of the first nanoribbon and a second portion of the second nanoribbon, and the second transistor includes a second channel region in a third portion of the third nanoribbon.

Example 14 provides the IC structure of any one of examples 10-13, further including a third transistor in the line, where the second transistor is between the first transistor and the third transistor.

Example 15 provides the IC structure of any one of examples 10-14, further including; a fourth nanoribbon extending substantially parallel with the first nanoribbon and the third nanoribbon, where: the fourth nanoribbon includes a first portion with a fourth width and a second portion with a fifth width, the first portion is closer to the first nanoribbon than the third nanoribbon and the second portion is closer to the third nanoribbon than the first nanoribbon, and the fourth width is smaller than the fifth width.

Example 16 provides an IC structure, including a first transistor (e.g., nanocomb transistor) over a substrate, where: the first transistor includes a first channel region in a first portion of a first nanoribbon and in a second portion of a second nanoribbon in a first plane that is substantially parallel with the substrate, and the first nanoribbon and the second nanoribbon are coupled with and separated by a region of a dielectric material in the first plane; and a second transistor over the substrate, where: the second transistor includes a second channel in a third nanoribbon in the first plane and a doped semiconductor region in the third nanoribbon, the doped semiconductor region is in a second plane that is substantially orthogonal to the substrate, substantially parallel with a first length of the first nanoribbon, and intersecting the region of the dielectric material, and the third nanoribbon is wider than the first nanoribbon.

Example 17 provides the IC structure of example 16, where: the first nanoribbon has a first width, the second nanoribbon has a second width, the third nanoribbon has a third width, and the third width is greater than equal to the first width and the second width combined.

Example 18 provides the IC structure of example 17, where: the region has a fourth width, and the third width is about equal to the first width, the second width, and the fourth width.

Example 19 provides the IC structure of example 17, where: the region has a fourth width, and the third width is smaller than the first width, the second width, and the fourth width.

Example 20 provides the IC structure of any one examples 16-19, further including a third transistor (e.g., nanocomb transistor) over the substrate, where: the third transistor includes a third channel region in a fourth portion of a fourth nanoribbon and in a fifth portion of a fifth nanoribbon in the first plane, the fourth nanoribbon and the fifth nanoribbon are coupled with and separated by a further region of the dielectric material in the first plane, and the further region of the dielectric material is in the second plane.

Example 21 provides an IC structure, including a first nanoribbon and a second nanoribbon of a semiconductor material over a substrate, where the first nanoribbon and the second nanoribbon are coplanar and substantially parallel with one another; a region of a dielectric material (e.g., spine) between, coplanar with, and coupled with the first nanoribbon and the second nanoribbon, where: a combined width of the first nanoribbon, the region, and the second nanoribbon is a dimension between a first plane at a first edge of the first nanoribbon and a second plane at a second edge of the second nanoribbon and in a third plane substantially parallel with the substrate, the first plane and the second plane are substantially parallel with a first length of the first nanoribbon and substantially orthogonal to the substrate; and a third nanoribbon of the semiconductor material, where: the third nanoribbon is coplanar with and substantially parallel with the first nanoribbon, and the third nanoribbon has a width between the first plane and the second plane, where the width is a dimension of the third nanoribbon in the third plane.

Example 22 provides an IC structure according to any one of examples 1-21, where the IC structure includes or is a part of a central processing unit.

Example 23 provides an IC structure according to any one of examples 1-22, where the IC structure includes or is a part of a memory device.

Example 24 provides an IC structure according to any one of examples 1-23, where the IC structure includes or is a part of a logic circuit.

Example 25 provides an IC structure according to any one of examples 1-24, where the IC structure includes or is a part of input/output circuitry.

Example 26 provides an IC structure according to any one of examples 1-25, where the IC structure includes or is a part of a FPGA transceiver.

Example 27 provides an IC structure according to any one of examples 1-26, where the IC structure includes or is a part of a FPGA logic.

Example 28 provides an IC structure according to any one of examples 1-27, where the IC structure includes or is a part of a power delivery circuitry.

Example 29 provides an IC package that includes an IC die including an IC structure according to any one of examples 1-28; and a further IC component, coupled to the IC die.

Example 30 provides an IC package according to example 29 where the further IC component includes a package substrate.

Example 31 provides an IC package according to example 29, where the further IC component includes an interposer.

Example 32 provides an IC package according to example 29, where the further IC component includes a further IC die.

Example 33 provides a computing device that includes a carrier substrate and an IC structure coupled to the carrier substrate, where the IC structure is an IC structure according to any one of examples 1-28, or the IC structure is included in the IC package according to any one of examples 29-32.

Example 34 provides a computing device according to example 33, where the computing device is a wearable or handheld computing device.

Example 35 provides a computing device according to examples 33 or 34, where the computing device further includes one or more communication chips.

Example 36 provides a computing device according to any one of examples 33-35, where the computing device further includes an antenna.

Example 37 provides a computing device according to any one of examples 33-36, where the carrier substrate is a motherboard.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a first nanoribbon and a second nanoribbon of a semiconductor material over a substrate, wherein:
the first nanoribbon and the second nanoribbon are coplanar and substantially parallel with one another,
the first nanoribbon has a first width, wherein the first width is a first dimension of the first nanoribbon in a plane substantially parallel with the substrate, and
the second nanoribbon has a second width, wherein the second width is a second dimension of the second nanoribbon in the plane;
a region of a dielectric material between, coplanar with, and coupled with the first nanoribbon and the second nanoribbon; and
a third nanoribbon of the semiconductor material, wherein:
the third nanoribbon is coplanar with, substantially parallel with the first nanoribbon, and extending along a same line as the first nanoribbon and the region,
the third nanoribbon has a third width, wherein the third width is a third dimension of the third nanoribbon in the plane, and
the third width is greater than the first width.

2. The IC structure of claim 1, wherein:
the third nanoribbon is in a second plane that is substantially orthogonal to the substrate, substantially parallel with the first nanoribbon, and intersecting the region of the dielectric material.

3. The IC structure of claims 1 or 2, further comprising:
a first transistor comprising a first channel region in a first portion of the first nanoribbon; and
a second transistor comprising a second channel region in a second portion of the third nanoribbon and a doped semiconductor region in the third nanoribbon, wherein the doped semiconductor region is a source region or a drain region of the second transistor, wherein:
the doped semiconductor region is in a second plane with the region of the dielectric material, wherein the second plane is substantially orthogonal to the substrate and substantially parallel with the first nanoribbon.

4. The IC structure of claim 3, wherein the first transistor comprises a first nanocomb transistor, and wherein the IC structure further comprises:
a second nanocomb transistor, wherein the second transistor is between the first nanocomb transistor and the second nanocomb transistor.

5. The IC structure of any one of claims 1-4, wherein:
the third width is greater than or equal to the first width plus the second width.

6. The IC structure of claim 5, wherein:
the region has a fourth width, and the third width is substantially equal to the first width plus the second width plus the fourth width.

7. The IC structure of claim 5, wherein:
the region has a fourth width, and the third width is smaller than the first width plus the second width plus the fourth width.

8. The IC structure of any one of claims 1-7, further comprising:
a fourth nanoribbon coplanar with, substantially parallel with, and adjacent to the third nanoribbon and the first nanoribbon, wherein:
the fourth nanoribbon comprises a first portion adjacent to the third nanoribbon, wherein the first portion has a fourth width, and a second portion adjacent to the first nanoribbon, wherein the second portion has a fifth width, and
the fourth width is greater than the fifth width.

9. The IC structure of any one of claims 1-8, wherein:
the first nanoribbon, the second nanoribbon, and the third nanoribbon are different portions of a same nanoribbon.

10. The IC structure of any one of claims 1-9, wherein:
the region comprises a dielectric wall over and substantially orthogonal to the substrate, wherein the dielectric wall has a first side and a second side opposite the first side, and
the first nanoribbon is coupled with the first side and the second nanoribbon is coupled with the second side.

11. The IC structure of claim 10, further comprising:
a stack of nanoribbons comprising the first nanoribbon, wherein the dielectric wall extends through the stack.

12. The IC structure of any one of claims 1-11, further comprising:
a gate insulator material around three sides of the first nanoribbon and around four sides of the third nanoribbon.

13. The IC structure of any one of claims 1-12, further comprising:
a fourth nanoribbon adjacent to the third nanoribbon and the first nanoribbon, wherein a first distance between the fourth nanoribbon and the first nanoribbon is substantially the same as a second distance between the fourth nanoribbon and the third nanoribbon.

14. The IC structure of claim 13, wherein:
the fourth nanoribbon has a fourth width, and
the fourth width is substantially the same as the third width.

15. The IC structure of any one of claims 13-14, further comprising:
a first transistor comprising a first channel region in the first nanoribbon and a first source or drain region; and
a second transistor comprising a second channel region in the fourth nanoribbon and a second source or drain region, wherein:
one of the first source or drain region and the second source or drain region comprises N-type dopants, and
another of the first source or drain region and the second source or drain region comprises P-type dopants.
